# EUROPÄISCHE PATENTANMELDUNG

(11) **EP 4 826 404 A1**
(43) Veröffentlichungstag der Anmeldung: **21.10.2026**
(21) Anmeldenummer: 25170983.8
(22) Anmeldetag: 16.04.2025
(51) Int. Cl.: G01R 31/54, B60L 53/18, G01R 31/58

(54) **PRÜFADAPTER ZUR FUNKTIONSPRÜFUNG EINES LADEKABELS FÜR ELEKTROFAHRZEUGE**

(71) Anmelder: KPS Prüfservice GmbH, 69493 Hirschberg (DE)
(72) Erfinder: Thume, Michael, 69493 Hirschberg (DE)
(74) Vertreter: Altmann Stößel Dick Patentanwälte PartG mbB

(57) **Zusammenfassung**

Es wird ein Prüfadapter (110) zur Funktionsprüfung mindestens eines Ladekabels für Elektrofahrzeuge vorgeschlagen. Der Prüfadapter (110) umfasst:
a. mindestens einen mehrpoligen ersten Steckeranschluss (112) zum Anschließen mindestens eines ladestationsseitigen Steckers (132) des Ladekabels;
b. mindestens einen mehrpoligen zweiten Steckeranschluss (114) zum Anschließen mindestens eines fahrzeugseitigen Steckers (136) des Ladekabels;
c. mindestens ein erstes Buchsenfeld (116) mit mindestens zwei Prüfbuchsen (118), wobei die Prüfbuchsen (118) mit unterschiedlichen Anschlüssen des ersten Steckeranschlusses (112) elektrisch verbunden sind und bei an den ersten Steckeranschluss (112) angeschlossenem ladestationsseitigen Stecker (132) des Ladekabels mit mindestens einem Prüfanschluss (140) mindestens eines Messgerätes (142) verbindbar sind; und
d. mindestens ein zweites Buchsenfeld (120) mit mindestens zwei Prüfbuchsen (118), wobei die Prüfbuchsen (118) mit unterschiedlichen Anschlüssen des zweiten Steckeranschlusses (114) elektrisch verbunden sind und bei an den zweiten Steckeranschluss (114) angeschlossenem fahrzeugseitigem Stecker (136) des Ladekabels mit mindestens einem Prüfanschluss (140) des Messgerätes (142) verbindbar sind.

## Beschreibung

### Technisches Gebiet

Die Erfindung betrifft einen Prüfadapter zur Funktionsprüfung mindestens eines Ladekabels für Elektrofahrzeuge. Weiterhin betrifft die Erfindung ein Prüfsystem zur Funktionsprüfung mindestens eines Ladekabels für Elektrofahrzeuge sowie ein Verfahren zur Funktionsprüfung mindestens eines Ladekabels für Elektrofahrzeuge. Der Prüfadapter, das Prüfsystem und das Verfahren können insbesondere im Bereich der elektrotechnischen Geräteprüfung von Ladekabeln für Elektrofahrzeuge eingesetzt werden. Auch andere Einsatzgebiete und Anwendungen sind jedoch grundsätzlich denkbar.

### Technischer Hintergrund

Elektrische Ladesäulen für Elektrofahrzeuge sind als ortsfeste elektrische Anlagen nach DGUV Vorschrift 3 prüfpflichtig. Die Prüfpflicht betrifft insbesondere auch die zur Übertragung der elektrischen Energie von der Ladesäule auf das zu ladende Elektrofahrzeug verwendeten Ladekabel. Die nach DGUV Vorschrift 3 vorgeschriebene Funktionsprüfung ist im Allgemeinen regelmäßig und durch eine ausgebildete Fachkraft durchzuführen. Damit erfordert diese Funktionsprüfung nicht zuletzt einen erheblichen personellen Aufwand. Es ist daher wünschenswert, die erforderliche Funktionsprüfung der Ladekabel zu vereinfachen.

DE 20 2023 000 863 U1 beschreibt einen Prüfadapter für Ladekabel von Elektrofahrzeugen, der aus einem stabilen Gehäuse mit Steckdosen oder Buchsen besteht, an die das zu prüfende Ladekabel technisch sicher angeschlossen wird. Das Ladekabel wird unverwechselbar bei der Prüfung angeschlossen. Das Gehäuse ist komplett geschlossen und in der notwendigen Schutzart vor Fremdkörpern und Feuchtigkeit ausgeführt.

DE 10 2023 105 985 A1 beschreibt ein Prüfgerät zur Prüfung einer Ladevorrichtung, insbesondere für batterieelektrische Fahrzeuge, mit einer Prüfschnittstelle zum Verbinden mit einer Ladevorrichtung. Das Prüfgerät weist wenigstens zwei Prüfeinheiten auf, wobei die Prüfeinheiten zur Durchführung verschiedener Prüfungen ausgebildet sind. Das Prüfgerät weist weiter eine Umschalteinheit, durch die die Prüfschnittstelle wahlweise mit einer der Prüfeinheiten verbindbar ist und eine Steuereinheit auf, die mit der Umschalteinheit und den Prüfeinheiten verbunden ist und die dazu eingerichtet ist eine Prüfung automatisiert durchzuführen.

Trotz der Vorteile, welche mit den vorbekannten Vorrichtungen und Verfahren erzielt werden, verbleiben mehrere technische Herausforderungen. So besteht weiterhin das Bedürfnis, die nach DGUV Vorschrift 3 erforderliche Funktionsprüfung von Ladekabeln zu vereinfachen, insbesondere derart, dass die Prüfung nicht nur durch eine Elektrofachkraft im Sinne dieser Vorschrift ausgeführt werden kann. Dies erfordert insbesondere auch die Bereitstellung einer technisch sicheren Möglichkeit, die verschiedenen vorgeschriebenen Prüfungen des Ladekabels technisch korrekt durchzuführen. Zudem wird eine Handhabung der vorbekannten Vorrichtungen durch die typischerweise verwendeten offenen Prüfspitzen regelmäßig erschwert. In der Praxis ist die mit der Prüfung beauftragte Fachkraft häufig gezwungen die Ladekabel mit den Beinen zu fixieren oder es ist eine zweite Fachkraft notwendig, um Ladekabel zu halten und so eine technisch sichere Handhabung zu gewährleisten.

### Aufgabe der Erfindung

Es wäre daher wünschenswert, einen Prüfadapter, ein Prüfsystem sowie ein Verfahren zur Funktionsprüfung mindestens eines Ladekabels für Elektrofahrzeuge bereitzustellen, welche die Nachteile bekannter Vorrichtung und Verfahren zumindest weitgehend vermeiden. Insbesondere soll ein Prüfadapter bereitgestellt werden, der die nach DGUV Vorschrift 3 erforderliche Funktionsprüfung von Ladekabeln vereinfacht, insbesondere derart, dass die Prüfung keine Elektrofachkraft im Sinne dieser Vorschrift erfordert, sondern beispielsweise lediglich noch eine Überwachung durch eine Elektrofachkraft stattfindet.

### Allgemeine Beschreibung der Erfindung

Diese Aufgabe wird adressiert durch einen Prüfadapter, ein Prüfsystem sowie ein Verfahren zur Funktionsprüfung mindestens eines Ladekabels für Elektrofahrzeuge mit den Merkmalen der unabhängigen Patentansprüche. Vorteilhafte Weiterbildungen, welche einzeln oder in beliebiger Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben den durch diese Begriffe eingeführten Merkmalen, keine weiteren Merkmale vorhanden sind, oder auf Situationen, in welchen ein oder mehrere weitere Merkmale vorhanden sind. Beispielsweise kann sich der Ausdruck "A hat B", "A weist B auf", "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe, wenn diese in Zusammenhang mit einem oder mehreren Elementen oder Merkmalen verwendet werden und ausdrücken sollen, dass das Element oder Merkmal einfach oder mehrfach vorgesehen sein kann, in der Regel lediglich einmalig verwendet werden, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

In einem ersten Aspekt der vorliegenden Erfindung wird ein Prüfadapter zur Funktionsprüfung mindestens eines Ladekabels für Elektrofahrzeuge vorgeschlagen. Der Prüfadapter umfasst:
a. mindestens einen mehrpoligen ersten Steckeranschluss zum Anschließen mindestens eines ladestationsseitigen Steckers des Ladekabels;
b. mindestens einen mehrpoligen zweiten Steckeranschluss zum Anschließen mindestens eines fahrzeugseitigen Steckers des Ladekabels;
c. mindestens ein erstes Buchsenfeld mit mindestens zwei Prüfbuchsen, wobei die Prüfbuchsen mit unterschiedlichen Anschlüssen des ersten Steckeranschlusses elektrisch verbunden sind und bei an den ersten Steckeranschluss angeschlossenem ladestationsseitigen Stecker des Ladekabels mit mindestens einem Prüfanschluss, insbesondere mindestens einer Messspitze, mindestens eines Messgerätes verbindbar sind; und
d. mindestens ein zweites Buchsenfeld mit mindestens zwei Prüfbuchsen, wobei die Prüfbuchsen mit unterschiedlichen Anschlüssen des zweiten Steckeranschlusses elektrisch verbunden sind und bei an den zweiten Steckeranschluss angeschlossenem fahrzeugseitigem Stecker des Ladekabels mit mindestens einem Prüfanschluss, insbesondere mindestens einer Messspitze, des Messgerätes verbindbar sind.

Der Begrifft "Prüfadapter", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Vorrichtung beziehen, welche zumindest eine Schnittstelle zwischen einem Prüfobjekt und einem oder mehreren Messgeräten bereitstellt. Der Prüfadapter kann dabei mehrere Schnittstellen umfassen, welche für Mess- und Prüfaufgaben der Funktionsprüfung des Ladekabels erforderlich sind, wie weiter unten noch detailliert ausgeführt wird. Der Prüfadapter kann insbesondere die für diese Mess- und Prüfaufgaben der Funktionsprüfung erforderlichen Schnittstellen derart bereitstellen, dass auch eine elektrotechnisch unterwiesene Person die Funktionsprüfung durchführen kann. Der Prüfadapter kann es somit ermöglichen, dass bei der Funktionsprüfung des Ladekabels auf die Anwesenheit einer Elektrofachkraft verzichtet werden kann.

Der Prüfadapter kann insbesondere als tragbarer Prüfadapter ausgestaltet sein. Hierbei können der erste Steckeranschluss, der zweite Steckeranschluss, das erste Buchsenfeld und das zweite Buchsenfeld in einem gemeinsamen Gehäuse angeordnet sein. Der Begriff "tragbar", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Eignung des Prüfadapters beziehen, von einem Benutzer getragen werden zu können. Der Prüfadapter kann also mit den im gemeinsamen Gehäuse angeordneten Bestandteilen, insbesondere mit sämtlichen Bestandteilen des Prüfadapters, durch einen Benutzer von einem ersten Ort zu einem zweiten, von dem ersten Ort verschiedenen Ort getragen werden, insbesondere ohne weitere maschinelle Unterstützung. Das Gehäuse kann einen Koffer umfassen. Das Gehäuse kann beispielsweise einen Hartschalenkoffer umfassen. Der tragbare Prüfadapter kann Dimensionen aufweisen, die es dem Benutzer ermöglichen, den Prüfadapter zu tragen. So kann der Prüfadapter eine Höhe, eine Breite und/oder eine Länge von nicht mehr als einem Meter, insbesondere von nicht mehr als einem halben Meter, aufweisen. Beispielsweise kann der Prüfadapter die Maße 41 cm x 32 cm x 17,5 cm aufweisen. Alternativ oder zusätzlich kann der Prüfadapter ein Gewicht von nicht mehr als 10 kg, bevorzugt von nicht mehr als 5 kg, besonders bevorzugt von nicht mehr als 4 kg, aufweisen. Beispielsweise kann der Prüfadapter ein Gewicht von ca. 3 kg, insbesondere mit den Maßen 41 cm x 32 cm x 17,5 cm, aufweisen.

Der Begrifft "Funktionsprüfung", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Ermittlung eines Ist-Zustandes mindestens einer Eigenschaft eines Prüfobjekts beziehen. Das Prüfobjekt kann insbesondere das Ladekabel (Mode3) und/oder das Notfallladekabel (Mode2) eines Elektrofahrzeugs sein. Die Funktionsprüfung kann weiterhin eine Beurteilung des ermittelten Ist-Zustandes umfassen. Die Beurteilung kann einen Vergleich des ermittelten Ist- Zustandes mit einem Soll-Zustand sowie eine Bewertung einer möglichen Abweichung des Ist-Zustandes vom Soll-Zustand umfassen, insbesondere gesondert für jede der geprüften Eigenschaften des Ladekabels. Die Ermittlung kann mindestens einen der folgenden Vorgänge umfassen: ein Besichtigen des Prüfobjekts auf augenscheinliche Mängel; ein Messen der mindestens einen Eigenschaft des Prüfobjekts, wie beispielsweise eine Durchgängigkeit der Schutzleiterverbindungen und/oder eine Größe des Isolationswiderstandes; ein Erproben, beispielweise von Sicherheitsfunktionen, Verriegelungen, Prüftaste der Fehlerstrom-Schutzeinrichtung (RCD), Schalt- und Kontrollleuchten, die der Sicherheit dienen.

Die Ermittlung des Ist-Zustandes der mindestens einen Eigenschaft des Prüfobjekts kann insbesondere das Messen dieser Eigenschaft des Prüfobjekts umfassen. Das Messen kann dabei einen Vorgang umfassen, bei dem, mit Hilfe von einer oder mehreren Messeinrichtungen, die Eigenschaft des Prüfobjekts festgestellt wird, welche insbesondere nicht durch Besichtigen erkannt werden kann. Die zu überprüfende Eigenschaft des Ladekabels kann beispielsweise eine Durchgängigkeit einer oder mehrerer Leiter des Ladekabels und/oder eine Größe eines Isolationswiderstands zwischen zwei Leitern des Ladekabels sein. Die Funktionsprüfung kann eine wiederkehrende Funktionsprüfung sein, insbesondere eine wiederkehrende Funktionsprüfung zur Sicherung des Erhalts des ordnungsgemäßen Zustands des Ladekabels. Die Funktionsprüfung kann insbesondere eine nach DGUV Vorschrift 3 erforderliche Funktionsprüfung sein.

Der Begriff "Ladekabel", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf mindestens eine mit Isolierstoffen ummantelte elektrische Leitung beziehen. Das Ladekabel kann insbesondere dazu eingerichtet sein, Drehstrom zu leiten, wobei das Ladekabel für jede der drei Phasen mindestens einen elektrischen Leiter umfassen kann. Das Ladekabel kann weiterhin mindestens einen Neutralleiter, sowie optional weitere Leitungen, beispielsweise Dateninformationsleitungen, umfassen. Das Ladekabel kann ausgewählt sein aus der Gruppe bestehend aus: einem Kabel für Drehstrom mit mindestens vier, insbesondere mindestens fünf Leitern; einem Kabel für Wechselstrom mit mindestens zwei, insbesondere mindestens drei Leitern. Das Ladekabel kann weiterhin mindestens eine Leitung aufweisen, ausgewählt aus der Gruppe bestehend aus einer Kontrollleitung und einer Datenleitung.

Das Ladekabel ist ein Ladekabel für Elektrofahrzeuge und kann daher dazu eingerichtet sein, ein Elektrofahrzeug mit elektrischer Energie zu versorgen, insbesondere elektrische Energie von einer Ladesäule an einen elektrischen Speicher des Elektrofahrzeugs weiterzuleiten. Das Ladekabel für Elektrofahrzeuge, im Folgenden auch kurz mit "Ladekabel" bezeichnet, kann dazu eingerichtet sein, elektrische Energie von einer Ladesäule an das Elektrofahrzeug während eines Ladevorgangs bereitzustellen, insbesondere an einem elektrischen Speicher des Elektrofahrzeugs zuzuführen. Das Ladekabel umfasst dabei einen ladestationsseitigen Stecker und einen fahrzeugseitigen Stecker. Das Ladekabel kann beispielsweise ein Ladekabel vom Typ 2 des IEC 62196 Standards sein. In diesem Fall umfasst das Ladekabel sowohl einen ladestationsseitigen Stecker wie auch einen fahrzeugseitigen Stecker vom Typ 2 des IEC 62196 Standards, kurz ein Ladekabel Typ 2 auf Typ 2. Grundsätzlich sind jedoch auch andere Ladekabeltypen denkbar, beispielsweise ein Ladekabel Typ 1 auf Typ 2, auch als "Mode-3-Kabel" bezeichnet.

Der Begriff "Elektrofahrzeuge", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein durch Maschinenkraft bewegtes, nicht an Schienen gebundenes Landfahrzeug beziehen, dessen Antriebsenergie in Form von elektrischer Energie bereitgestellt wird. Das Elektrofahrzeug kann insbesondere ein elektrisches Kraftfahrzeug sein, beispielweise ein Elektroauto, ein elektrisches Leichtkraftfahrzeug, ein elektrisches Kraftrad, ein Elektromotorrad, ein Elektrobus, ein Elektrolastkraftwagen, eine elektrische Zugmaschine und/oder andere elektrische Kraftfahrzeuge. Das Elektrofahrzeug kann mindestens einen elektrischen Energiespeicher aufweisen, welcher dazu eingerichtet ist, Energie in Form von elektrischer Energie zu speichern und zum Zwecke des Antriebs des Elektrofahrzeugs an eine Antriebsvorrichtung, beispielsweise einen Motor, abzugeben. Der elektrische Energiespeicher kann dabei ein aufladbarer elektrischer Energiespeicher sein.

Wie oben aufgeführt, umfasst der Prüfadapter den mindestens einen mehrpoligen ersten Steckeranschluss zum Anschließen des ladestationsseitigen Steckers des Ladekabels und den mindestens einen mehrpoligen zweiten Steckeranschluss zum Anschließen des fahrzeugseitigen Steckers des Ladekabels.

Die Begriffe "erster" oder "zweiter" sowie gegebenenfalls weitere Nummerierungen im Folgenden im Zusammenhang mit Begriffen werden als reine Nomenklatur verwendet, ohne hierdurch eine Reihenfolge, eine Rangfolge oder eine konkrete Anzahl anzugeben. So können beispielsweise auch mehrere erste Steckeranschlüsse und/oder mehrere zweite Steckeranschlüsse vorgesehen sein.

Der Begriff "Steckeranschluss", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen Teil einer elektrischen Steckverbindung beziehen. Der Steckeranschluss kann einen männlichen Teil oder einen weiblichen Teil der elektrischen Steckverbindung umfassen. Der Steckeranschluss kann dazu eingerichtet sein, bei einem mechanischen Verbinden eines zum Steckeranschluss gehörigen Steckers mit dem Steckeranschluss eine elektrisch leitende Verbindung zwischen dem Stecker und dem Steckeranschluss herzustellen. Der Steckeranschluss kann weiterhin dazu eingerichtet sein, mit einem dazugehörigen Stecker eine formschlüssige Verbindung einzugehen, welche optional kraftschlüssig lösbar fixiert werden kann. Der erste Steckeranschluss kann beispielsweise einen Einbaustecker für den ladestationsseitigen Stecker des Ladekabels aufweisen. Der zweite Steckeranschluss kann beispielsweise eine Buchse für den fahrzeugseitigen Stecker des Ladekabels aufweisen.

Der erste und der zweite Steckeranschluss können den Anschluss der Stecker eines Ladekabels nach dem IEC 62196 Standard ermöglichen, insbesondere eines Ladekabels vom Typ 2 des IEC 62196 Standards.

Der Begriff "mehrpolig", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine Eigenschaft eines Steckeranschlusses beziehen, zumindest zwei verschiedene elektrische Pole aufzunehmen bzw. von mindestens zwei verschiedenen elektrischen Polen aufgenommen zu werden. Insbesondere kann der mehrpolige Steckeranschluss dazu geeignet sein, einen Stecker nach Typ 2 des IEC 62196 Standards aufzunehmen bzw. von einer solchen Steckerkupplung aufgenommen zu werden. Der mehrpolige Steckeranschluss kann jeweils einen elektrischen Pol für die folgenden Anschlüsse aufweisen: einen Schutzleiter-Anschluss (PE); einen Neutraleiter-Anschluss (N); einen L1-Anschluss; einen L2-Anschluss; einen L3-Anschluss; einen Anschluss für eine Kontrolldatenleitung (CP); einen Anschluss für eine Datenleitung (PP).

Der Begriff "ladestationsseitiger Stecker", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen Teil einer Steckverbindung des Ladekabels beziehen, welche dazu eingerichtet ist, an eine Ladestation für Elektrofahrzeug angeschlossen zu werden. Der ladestationsseitige Stecker des Ladekabels kann eine Steckerkupplung, insbesondere eine Steckerkupplung nach Typ 2 des IEC 62196 Standards, umfassen.

Der Begriff "fahrzeugseitiger Stecker", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen Teil einer Steckverbindung des Ladekabels beziehen, welche dazu eingerichtet ist, an das Elektrofahrzeug angeschlossen zu werden. Der fahrzeugseitige Stecker des Ladekabels kann einen Stecker, insbesondere einen Stecker nach Typ 2 des IEC 62196 Standards, umfassen.

Wie oben aufgeführt, umfasst der Prüfadapter das mindestens eine erste Buchsenfeld mit mindestens zwei Prüfbuchsen, wobei die Prüfbuchsen mit unterschiedlichen Anschlüssen des ersten Steckeranschlusses elektrisch verbunden sind und bei an den ersten Steckeranschluss angeschlossenem ladestationsseitigen Stecker des Ladekabels mit mindestens einem Prüfanschluss, insbesondere mindestens einer Messspitze, mindestens eines Messgerätes verbindbar sind, und das mindestens eine zweite Buchsenfeld mit mindestens zwei Prüfbuchsen, wobei die Prüfbuchsen mit unterschiedlichen Anschlüssen des zweiten Steckeranschlusses elektrisch verbunden sind und bei an den zweiten Steckeranschluss angeschlossenem fahrzeugseitigem Stecker des Ladekabels mit mindestens einem Prüfanschluss, insbesondere mindestens einer Messspitze, des Messgerätes verbindbar sind.

Der Begriff "Prüfbuchsen", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine äußere Form einer einpoligen Steckverbindung beziehen. Die Prüfbuchse kann dazu eingerichtet sein, bei einem mechanischen Verbinden des Prüfanschlusses des Messergeräts mit der Prüfbuchse eine elektrisch leitende Verbindung zwischen dem Prüfanschluss und der Prüfbuchse herzustellen. Hierbei kann der Prüfanschluss die zugehörige innere Form der einpoligen Steckverbindung aufweisen. Die Prüfbuchse kann weiterhin dazu eingerichtet sein, mit dem Prüfanschluss des Messgeräts eine formschlüssige Verbindung einzugehen, welche optional kraftschlüssig lösbar fixiert werden kann. Die Prüfbuchse kann dazu eingerichtet sein, eine Schnittstelle bereitzustellen, über welche eine elektrische Verbindung mit einem zugehörigen Anschluss des ersten oder zweiten Steckeranschlusses hergestellt werden kann.

Der Begriff "Buchsenfeld", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen räumlich zusammenhängenden Bereich mehrerer Prüfbuchsen beziehen. Die Prüfbuchsen eines Buchsenfeldes können beispielsweise im Prüfadapter in einem räumlich zusammenhängenden Bereich angeordnet sein, insbesondere derart angeordnet und/oder gekennzeichnet, dass eine Zuordnung der Prüfbuchsen des ersten Buchsenfeldes zum ersten Steckeranschluss und/oder eine Zuordnung der Prüfbuchsen des zweiten Buchsenfeldes zum zweiten Steckeranschluss erkennbar ist. Das Buchsenfeld kann dabei einen einzigen zusammenhängenden Bereich umfassen, in welchem die Prüfbuchsen angeordnet sind. Alternativ kann das Buchsenfeld jedoch auch mehrere Teilbereiche umfassen, wobei jeder Teilbereich zumindest zwei Prüfbuchsen umfassen kann und die Teilbereiche voneinander räumlich getrennt im Prüfadapter angeordnet sein können. Auch die Teilbereiche können derart angeordnet und/oder gekennzeichnet sein, dass eine Zuordnung der Prüfbuchsen des ersten Buchsenfeldes zum ersten Steckeranschluss und/oder eine Zuordnung der Prüfbuchsen des zweiten Buchsenfeldes zum zweiten Steckeranschluss erkennbar ist.

Zur Funktionsprüfung des Ladekabels für Elektrofahrzeuge kann das Ladekabel mit dem ersten Steckeranschluss und dem zweiten Steckeranschluss des Prüfadapters verbunden werden. Das erste Buchsenfeld und das zweite Buchsenfeld können eine Schnittstelle für das Messgerät zur Beprobung der an die Steckeranschlüsse angeschlossenen Leiter des Ladekabels bereitstellen.

Der Begriff "Messgerät", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein elektrotechnisches Messgerät beziehen. Das Messgerät kann dazu eingerichtet sein, mindestens eine elektrische Größe zu messen. Beispielsweise kann das Messgerät dazu eingerichtet sein, eine elektrische Stromstärke, eine elektrische Spannung und/oder einen ohmschen Widerstand zu messen. Das Messgerät kann ein Spannungsmessgerät, ein Strommessgerät und/oder ein Widerstandsmessgerät umfassen. Das Messgerät kann beispielsweise ausgewählt sein aus der Gruppe bestehend aus: einem Multimeter, insbesondere einem Digitalmultimeter; einem Prüfgerät, welches der DIN EN IEC 61557-1 (VDE 0413-1): 2022-12 entspricht. Das Messgerät kann ein externes Messgerät sein, d.h. ein nicht von dem Prüfadapter umfasstes oder nicht in den Prüfadapter integriertes Messgerät.

Der Begriff "Prüfanschluss", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine der Prüfbuchse entsprechenden inneren Form einer einpoligen Steckverbindung beziehen. Der Prüfanschluss kann insbesondere eine Messspitze umfassen. Der Prüfanschluss kann dazu eingerichtet sein, eine elektrisch leitende Verbindung zwischen der Prüfbuchse und dem Messgerät herzustellen, falls der Prüfanschluss mit der jeweiligen Prüfbuchse verbunden ist.

Die Steckeranschlüsse und die Prüfbuchsen können derart ausgestaltet sein, dass jedem Anschluss in dem ladestationsseitigen Stecker des Ladekabels mindestens eine Prüfbuchse des ersten Buchsenfeldes elektrisch zugeordnet ist, und dass jedem Anschluss in dem fahrzeugseitigen Stecker des Ladekabels mindestens eine Prüfbuchse des zweiten Buchsenfeldes elektrisch zugeordnet ist. Beispielsweise kann das erste Buchsenfeld jeweils eine Prüfbuchse aufweisen, die einem der folgenden Anschlüsse des ladestationsseitigen Steckers des Ladekabels zugeordnet ist: einem PE-Anschluss; einem N-Anschluss; einem L1-Anschluss; einem L2-Anschluss; einem L3-Anschluss. Ebenso kann das zweite Buchsenfeld jeweils eine Prüfbuchse aufweisen, die einem der folgenden Anschlüsse des fahrzeugseitigen Steckers des Ladekabels zugeordnet ist: einem PE-Anschluss; einem N-Anschluss; einem L1-Anschluss; einem L2-Anschluss; einem L3-Anschluss.

Mindestens einer der Steckeranschlüsse kann zusätzlich mindestens einen Kodierungsanschluss zum Erfassen einer Kodierung eines maximalen Ladestroms des Ladekabels aufweisen. Zusätzlich kann das erste Buchsenfeld mindestens eine Prüfbuchse aufweisen, welche mit dem Kodierungsanschluss des ersten Steckeranschlusses elektrisch verbunden ist. Alternativ oder zusätzlich kann das zweite Buchsenfeld zusätzlich mindestens eine Prüfbuchse aufweisen, welche mit dem Kodierungsanschluss des zweiten Steckeranschlusses elektrisch verbunden ist.

Mindestens einer der Steckeranschlüsse kann zusätzlich mindestens einen Ladekabel-Erkennungsanschluss zum Erfassen eines Anschlusses eines Ladekabels aufweisen. Zusätzlich kann das erste Buchsenfeld mindestens eine Prüfbuchse aufweisen, welche mit dem Ladekabel-Erkennungsanschluss des ersten Steckeranschlusses elektrisch verbunden ist. Alternativ oder zusätzlich kann das zweite Buchsenfeld zusätzlich mindestens eine Prüfbuchse aufweisen, welche mit dem Ladekabel-Erkennungsanschluss des zweiten Steckeranschlusses elektrisch verbunden ist.

Der Prüfadapter kann weiterhin derart ausgestaltet sein, um zusätzlich mindestens ein Notladekabel für Elektrofahrzeuge einer Funktionsprüfung zu unterziehen. Der Prüfadapter kann weiterhin aufweisen:
e. mindestens einen mehrpoligen dritten Steckeranschluss, wobei der mehrpolige dritte Steckeranschluss als Schutzkontakt-Steckeranschluss ausgestaltet ist, insbesondere nach CEE 7/4.

Zur Funktionsprüfung des Notladekabels kann das Notladekabel mit dem dritten Steckeranschluss sowie dem zweiten Steckeranschluss verbunden werden. Der Prüfadapter kann weiterhin mindestens einen Anschluss zur Verbindung mit einer Kaltgerätekupplung umfassen. Der Anschluss zur Verbindung mit einer Kaltgerätekupplung kann dazu eingerichtet sein, um den Prüfadapter mit einer Prüfsteckdose des Mess- oder Prüfgerätes über eine Kaltgeräteleitung zu verbinden. Der Anschluss zur Verbindung mit einer Kaltgerätekupplung kann mit dem zweiten Steckeranschluss und dem dritten Steckeranschluss derart elektrisch verbunden sein, dass eine Spannungsversorgung für die Funktionsprüfung des Notladekabels über eine an den Anschluss zur Verbindung mit einer Kaltgerätekupplung angeschlossene Kaltgeräteleitung erfolgen kann. Der Prüfadapter kann weiterhin mindestens eine Schnittstelle zur Einstellung eines Ladestatus und/oder eines Ladstroms für die Funktionsprüfung des Notladekabels umfassen.

In einem weiteren Aspekt der vorliegenden Erfindung wird ein Prüfsystem zur Funktionsprüfung mindestens eines Ladekabels für Elektrofahrzeuge vorgeschlagen. Das Prüfsystem umfasst:
I. mindestens einen erfindungsgemäßen Prüfadapter, beispielsweise gemäß einer der oben beschriebenen Ausführungsformen und/oder gemäß einer der nachfolgend beschriebenen Ausführungsformen;
II. mindestens ein Messgerät mit mindestens zwei Prüfanschlüssen zum Anschließen an die Prüfbuchsen der Buchsenfelder des Prüfadapters.

Der Begriff "Prüfsystem", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf eine aus mindestens zwei Komponenten zusammengesetzte Einheit beziehen, wobei die Komponenten eingerichtet sind, um funktionell zur Erreichung mindestens eines Zwecks des Systems zusammen zu wirken. Die Komponenten können dabei miteinander mechanisch und/oder elektrisch verbunden sein, insbesondere reversibel. Der Prüfadapter und das Messgerät des Prüfsystems können unabhängig voneinander gehandhabt werden und können weiterhin dazu eingerichtet sein, elektrisch miteinander verbunden werden, um die Funktionsprüfung des Ladekabels und/oder des Notladekabels zu ermöglichen.

Für weitere Definition und/oder mögliche Ausgestaltungen, insbesondere des Prüfadapters, wird auf die obigen Ausführungen zum Prüfadapter verwiesen.

Das Messgerät kann insbesondere ausgewählt sein aus der Gruppe bestehend aus: einem Multimeter, insbesondere einem Digitalmultimeter; einem Prüfgerät, welches der DIN EN IEC 61557-1 (VDE 0413-1): 2022-12 entspricht.

In einem weiteren Aspekt der vorliegenden Erfindung wird ein Verfahren zur Funktionsprüfung mindestens eines Ladekabels für Elektrofahrzeuge vorgeschlagen. Das Verfahren umfasst die Verwendung mindestens eines erfindungsgemäßen Prüfadapters, beispielsweise gemäß einer der oben beschriebenen Ausführungsformen und/oder gemäß einer der nachfolgend beschriebenen Ausführungsformen.

Das Verfahren umfasst die nachfolgend beschriebenen Schritte. Die beschriebenen Schritte können insbesondere in der genannten Reihenfolge durchgeführt werden. Auch eine andere Reihenfolge ist jedoch grundsätzlich möglich. Weiterhin ist es möglich, dass zwei oder mehr der Verfahrensschritte zeitlich überlappend oder gleichzeitig durchgeführt werden. Weiterhin ist es möglich, dass einer oder mehrere der Verfahrensschritte einfach oder auch mehrfach wiederholt durchgeführt werden. Das Verfahren kann weitere Verfahrensschritte umfassen, welche nicht dargestellt sind.

Das Verfahren umfasst die folgenden Schritte:
i. Anschließen mindestens eines ladestationsseitigen Steckers des Ladekabels an den ersten Steckeranschluss des Prüfadapters;
ii. Anschließen mindestens eines fahrzeugseitigen Steckers des Ladekabels an den zweiten Steckeranschluss des Prüfadapters;
iii. Verbinden mindestens zweier Prüfanschlüsse mindestens eines Messgerätes mit mindestens zwei Prüfbuchsen der Buchsenfelder; und
iv. Erfassen mindestens eines elektrischen Parameters des Ladekabels mittels des Messgerätes.

Der Begriff "Anschließen", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Herstellen einer Verbindung einer elektrischen Steckverbindung beziehen. Das Anschließen kann insbesondere das mechanische Verbinden zweier Teile einer elektrischen Steckverbindung umfassen, wodurch eine elektrisch leitende Verbindung zwischen dem Stecker und dem Steckeranschluss der elektrischen Steckverbindung hergestellt wird. Durch das Anschließen des ladestationsseitigen Steckers an den ersten Steckeranschluss bzw. des fahrzeugseitigen Steckers an den zweiten Steckeranschluss kann eine elektrisch leitende Verbindung zwischen diesen Komponenten hergestellt werden.

Der Begriff "Verbinden", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf ein Herstellen einer elektrisch leitenden Verbindung beziehen. Das Verbinden der Prüfanschlüsse des Messgeräts mit den Prüfbuchsen kann ein Herstellen einer elektrisch leitenden Verbindung zwischen dem Messgerät und dem Prüfadapter umfassen.

Der Begriff "Erfassen", wie er hier verwendet wird, ist ein weiter Begriff, dem seine gewöhnliche und gängige Bedeutung beigemessen werden soll, wie der Fachmann sie versteht. Der Begriff ist nicht beschränkt auf eine spezielle oder angepasste Bedeutung. Der Begriff kann, ohne Beschränkung, sich insbesondere auf einen Messvorgang mindestens eines elektrischen Parameters beziehen. Das Erfassen kann dabei einen Vorgang umfassen, bei dem mit Hilfe des Messgeräts der mindestens eine elektrische Parameter des Ladekabels und/oder des Notladekabels festgestellt wird. Der elektrische Parameter kann ausgewählt sein aus der Gruppe bestehend aus: einem Leitungswiderstand des Ladekabels; einem Isolationswiderstand des Ladekabels. Zum Erfassen des mindestens einen elektrischen Parameters kann ein Messgerät, welches ausgewählt ist aus der Gruppe bestehend aus einem Multimeter, insbesondere einem Digitalmultimeter und einem Prüfgerät gemäß der DIN EN IEC 61557-1 (VDE 0413-1): 2022-12, verwendet werden.

Das Verfahren kann weiterhin eine Messung eines Innenwiderstandes des Prüfadapters umfassen, insbesondere vor Verfahrensschritt i..

Zwischen Verfahrensschritt i. und Verfahrensschritt ii. kann weiterhin eine Messung eines Widerstandswerts zwischen einem PE-Anschluss und einem Kodierungsanschluss des ladestationsseitigen Steckers durchgeführt werden. Die Messung des Widerstandwerts zwischen dem PE-Anschluss und dem Kodierungsanschluss des ladestationsseitigen Steckers kann mit am ersten Steckeranschluss angeschlossenem ladestationsseitigen Stecker aber ohne am zweiten Steckeranschluss angeschlossenen fahrzeugseitigen Stecker erfolgen.

In Verfahrensschritt iv. kann mindestens einer der folgenden elektrischen Parameter des Ladekabels erfasst werden, insbesondere alle der folgenden elektrischen Parameter in der angegebenen Reihenfolge:
- ein Leitungswiderstand eines Schutzleiters PE;
- ein Leitungswiderstand eines Neutralleiters N;
- ein Leitungswiderstand eines Außenleiters L1;
- ein Leitungswiderstand eines Außenleiters L2; und
- ein Leitungswiderstand eines Außenleiters L3.

Für die Erfassung dieser elektrischen Parameter kann sowohl der ladestationsseitige Stecker am ersten Steckeranschluss wie auch der fahrzeugseitige Stecker am zweiten Steckeranschluss angeschlossen sein. Die Einhaltung der Reihenfolge der Erfassung der elektrischen Parameter kann insbesondere die vollständige Erfassung aller erforderlichen Parameter sicherstellen sowie die Dokumentation der Messergebnisse erleichtern.

Alternativ oder zusätzlich kann in Verfahrensschritt iv. mindestens einer der folgenden elektrischen Parameter des Ladekabels erfasst werden, insbesondere alle der folgenden elektrischen Parameter in der angegebenen Reihenfolge:
- ein Isolationswiderstand zwischen Schutzleiter PE und Außenleiter L1;
- ein Isolationswiderstand zwischen Schutzleiter PE und Außenleiter L2;
- ein Isolationswiderstand zwischen Schutzleiter PE und Außenleiter L3;
- ein Isolationswiderstand zwischen Schutzleiter PE und Neutalleiter N;
- ein Isolationswiderstand zwischen Neutralleiter N und Außenleiter L1;
- ein Isolationswiderstand zwischen Neutralleiter N und Außenleiter L2;
- ein Isolationswiderstand zwischen Neutralleiter N und Außenleiter L3;
- ein Isolationswiderstand zwischen Außenleiter L3 und Außenleiter L2;
- ein Isolationswiderstand zwischen Außenleiter L3 und Außenleiter L1; und
- ein Isolationswiderstand zwischen Außenleiter L1 und Außenleiter L2.

Für die Erfassung dieser elektrischen Parameter kann nur der ladestationsseitige Stecker am ersten Steckeranschluss, nicht jedoch der fahrzeugseitige Stecker am zweiten Steckeranschluss angeschlossen sein. Die Einhaltung der Reihenfolge der Erfassung der elektrischen Parameter kann insbesondere die vollständige Erfassung aller erforderlichen Parameter sicherstellen sowie die Dokumentation der Messergebnisse erleichtern.

Das Verfahren kann weiterhin eine Sichtprüfung des Ladekabels umfassen, insbesondere vor einem Erfassen des elektrischen Parameters in Schritt iv..

Der Prüfadapter kann weiterhin, wie oben beschrieben, dazu ausgestaltet sein, um zusätzlich mindestens ein Notladekabel für Elektrofahrzeuge einer Funktionsprüfung zu unterziehen. Hierfür kann der Prüfadapter weiterhin aufweisen:
- mindestens einen mehrpoligen dritten Steckeranschluss, wobei der mehrpolige dritte Steckeranschluss als Schutzkontakt-Steckeranschluss ausgestaltet ist, insbesondere nach CEE 7/4; und
- mindestens einen Anschluss zur Verbindung mit einer Kaltgerätekupplung.

Das Verfahren kann in diesem Fall weiterhin umfassen:
v. Anschließen eines Schutzkontaktsteckers des Notladekabels an den dritten Steckeranschluss und des fahrzeugseitigen Steckers des Notladekabels an den zweiten Steckeranschluss des Prüfadapters;
vi. Verbinden des Messgeräts mit dem Prüfadapter über den Anschluss zur Verbindung mit einer Kaltgerätekupplung mittels einer Kaltgeräteleitung; und
vii. Durchführen der Funktionsprüfung des Notladekabels.

Die Funktionsprüfung des Notladekabels kann über das Messgerät laufen, sobald der Prüfkreis geschlossen ist, also insbesondere nach Schritt vi.. Ein Digitalmultimeter kann zum Messen des Widerstands (Ladestromkodierung) verwendet werden.

Die Funktionsprüfung des Notladekabels kann das Erfassen mindestens eines elektrischen Parameters des Notladekabels mittels des Messgeräts umfassen, wobei mindestens einer der folgenden elektrischen Parameter erfasst wird, insbesondere alle der folgenden elektrischen Parameter in der angegebenen Reihenfolge:
- ein Leitungswiderstand eines Schutzleiters PE;
- ein Isolationswiderstand zwischen Schutzleiter und Außenleiter L/Neutralleiter N;
- ein Schutzleiterstrom von Außenleiter L über Neutralleiter N;
- ein Schutzleiterstrom von Neutralleiter N über Außenleiter L;
- ein CP-Status eines Kodierungsanschlusses; und
- eine Auslösezeit einer Fehlerstrom-Schutzeinrichtung (PRCD Auslösezeit).

Insbesondere kann die Erfassung des CP-Status des Kodierungsanschlusses wichtig sein für die Funktion zumindest eines Ladestatus von B, C und E. Beispielsweise kann diese Erfassung auch normativ gefordert sein.

Die Einhaltung der Reihenfolge der Erfassung der elektrischen Parameter kann insbesondere die vollständige Erfassung aller erforderlichen Parameter sicherstellen sowie die Dokumentation der Messergebnisse erleichtern.

Das Verfahren kann weiterhin eine Sichtprüfung des Notladekabels umfassen, insbesondere vor dem Durchführen der Funktionsprüfung des Notladekabels in Schritt vii..

Der vorgeschlagene Prüfadapter, das vorgeschlagene Prüfsystem, sowie das vorgeschlagene Verfahren weisen gegenüber bekannten Vorrichtungen und Verfahren zahlreiche Vorteile auf. So können der erfindungsgemäße Prüfadapter, das Prüfsystem und das Verfahren eine vereinfachte Durchführung der nach DGUV Vorschrift 3 erforderlichen Funktionsprüfung von Ladekabeln ermöglichen, insbesondere derart, dass die Prüfung keine Elektrofachkraft im Sinne dieser Vorschrift erfordert und sondern auch von elektrotechnisch unterwiesenen Personen durchgeführt werden kann. Weiterhin kann insbesondere der Prüfadapter eine vereinfachte Bauweise bereitstellen, insbesondere ohne eine aufwendige und komplizierte Verschaltung wie sie in Prüfadaptern mit integrierten Mess- oder Prüfgeräten erforderlich ist.

Zusammenfassend werden, ohne Beschränkung weiterer möglicher Ausgestaltungen, folgende Ausführungsformen vorgeschlagen:
Ausführungsform 1: Prüfadapter zur Funktionsprüfung mindestens eines Ladekabels für Elektrofahrzeuge, umfassend:
   a. mindestens einen mehrpoligen ersten Steckeranschluss zum Anschließen mindestens eines ladestationsseitigen Steckers des Ladekabels;
   b. mindestens einen mehrpoligen zweiten Steckeranschluss zum Anschließen mindestens eines fahrzeugseitigen Steckers des Ladekabels;
   c. mindestens ein erstes Buchsenfeld mit mindestens zwei Prüfbuchsen, wobei die Prüfbuchsen mit unterschiedlichen Anschlüssen des ersten Steckeranschlusses elektrisch verbunden sind und bei an den ersten Steckeranschluss angeschlossenem ladestationsseitigen Stecker des Ladekabels mit mindestens einem Prüfanschluss, insbesondere mindestens einer Messspitze, mindestens eines Messgerätes verbindbar sind; und
   d. mindestens ein zweites Buchsenfeld mit mindestens zwei Prüfbuchsen, wobei die Prüfbuchsen mit unterschiedlichen Anschlüssen des zweiten Steckeranschlusses elektrisch verbunden sind und bei an den zweiten Steckeranschluss angeschlossenem fahrzeugseitigem Stecker des Ladekabels mit mindestens einem Prüfanschluss, insbesondere mindestens einer Messspitze, des Messgerätes verbindbar sind.
Ausführungsform 2: Prüfadapter nach der vorhergehenden Ausführungsform, wobei der Prüfadapter als tragbarer Prüfadapter ausgestaltet ist und wobei der erste Steckeranschluss, der zweite Steckeranschluss, das erste Buchsenfeld und das zweite Buchsenfeld in einem gemeinsamen Gehäuse angeordnet sind.
Ausführungsform 3: Prüfadapter nach der vorhergehenden Ausführungsform, wobei das Gehäuse einen Koffer umfasst.
Ausführungsform 4: Prüfadapter nach einer der vorhergehenden Ausführungsformen, wobei die Steckeranschlüsse und die Prüfbuchsen derart ausgestaltet sind, dass jedem Anschluss in dem ladestationsseitigen Stecker des Ladekabels mindestens eine Prüfbuchse des ersten Buchsenfeldes elektrisch zugeordnet ist, und dass jedem Anschluss in dem fahrzeugseitigen Stecker des Ladekabels mindestens eine Prüfbuchse des zweiten Buchsenfeldes elektrisch zugeordnet ist.
Ausführungsform 5: Prüfadapter nach der vorhergehenden Ausführungsform, wobei das erste Buchsenfeld jeweils eine Prüfbuchse aufweist, die einem der folgenden Anschlüsse des ladestationsseitigen Steckers des Ladekabels zugeordnet ist: einem PE-Anschluss; einem N-Anschluss; einem L1-Anschluss; einem L2-Anschluss; einem L3-Anschluss.
Ausführungsform 6: Prüfadapter nach einer der zwei vorhergehenden Ausführungsformen, wobei das zweite Buchsenfeld jeweils eine Prüfbuchse aufweist, die einem der folgenden Anschlüsse des fahrzeugseitigen Steckers des Ladekabels zugeordnet ist: einem PE-Anschluss; einem N-Anschluss; einem L1-Anschluss; einem L2-Anschluss; einem L3-Anschluss.
Ausführungsform 7: Prüfadapter nach einer der vorhergehenden Ausführungsformen, wobei das Ladekabel ausgewählt ist aus der Gruppe bestehend aus: einem Kabel für Drehstrom mit mindestens vier, insbesondere mindestens fünf Leitern; einem Kabel für Wechselstrom mit mindestens zwei, insbesondere mindestens drei Leitern.
Ausführungsform 8: Prüfadapter nach einer der vorhergehenden Ausführungsformen, wobei das Ladekabel weiterhin mindestens eine Leitung aufweist, ausgewählt aus der Gruppe bestehend aus einer Kontrollleitung und einer Datenleitung.
Ausführungsform 9: Prüfadapter nach einer der vorhergehenden Ausführungsformen, wobei mindestens einer der Steckeranschlüsse zusätzlich mindestens einen Kodierungsanschluss zum Erfassen einer Kodierung eines maximalen Ladestroms des Ladekabels aufweist.
Ausführungsform 10: Prüfadapter nach der vorhergehenden Ausführungsform, wobei das erste Buchsenfeld zusätzlich mindestens eine Prüfbuchse aufweist, welche mit dem Kodierungsanschluss des ersten Steckeranschlusses elektrisch verbunden ist und/oder wobei das zweite Buchsenfeld zusätzlich mindestens eine Prüfbuchse aufweist, welche mit dem Kodierungsanschluss des zweiten Steckeranschlusses elektrisch verbunden ist.
Ausführungsform 11: Prüfadapter nach einer der vorhergehenden Ausführungsformen, wobei mindestens einer der Steckeranschlüsse zusätzlich mindestens einen Ladekabel-Erkennungsanschluss zum Erfassen eines Anschlusses eines Ladekabels aufweist.
Ausführungsform 12: Prüfadapter nach der vorhergehenden Ausführungsform, wobei das erste Buchsenfeld zusätzlich mindestens eine Prüfbuchse aufweist, welche mit dem Ladekabel-Erkennungsanschluss des ersten Steckeranschlusses elektrisch verbunden ist und/oder wobei das zweite Buchsenfeld zusätzlich mindestens eine Prüfbuchse aufweist, welche mit dem Ladekabel-Erkennungsanschluss des zweiten Steckeranschlusses elektrisch verbunden ist.
Ausführungsform 13: Prüfadapter nach einer der vorhergehenden Ausführungsformen, wobei der erste und der zweite Steckeranschluss den Anschluss der Stecker eines Ladekabels nach dem IEC 62196 Standard ermöglichen, insbesondere eines Ladekabels vom Typ 2 des IEC 62196 Standards.
Ausführungsform 14: Prüfadapter nach einer der vorhergehenden Ausführungsformen, wobei der Prüfadapter weiterhin ausgestaltet ist, um zusätzlich mindestens ein Notladekabel für Elektrofahrzeuge einer Funktionsprüfung zu unterziehen und wobei der Prüfadapter weiterhin aufweist:
   e. mindestens einen mehrpoligen dritten Steckeranschluss, wobei der mehrpolige dritte Steckeranschluss als Schutzkontakt-Steckeranschluss ausgestaltet ist, insbesondere nach CEE 7/4.
Ausführungsform 15: Prüfadapter nach der vorhergehenden Ausführungsform, wobei der Prüfadapter weiterhin mindestens einen Anschluss zur Verbindung mit einer Kaltgerätekupplung umfasst.
Ausführungsform 16: Prüfadapter nach einem der zwei vorhergehenden Ausführungsformen, wobei der Prüfadapter weiterhin mindestens eine Schnittstelle zur Einstellung eines Ladestatus und/oder eines Ladstroms für die Funktionsprüfung des Notladekabels umfasst.
Ausführungsform 17: Prüfsystem zur Funktionsprüfung mindestens eines Ladekabels für Elektrofahrzeuge, umfassend:
   I. mindestens einen Prüfadapter nach einer der vorhergehenden Ausführungsformen;
   II. mindestens ein Messgerät mit mindestens zwei Prüfanschlüssen zum Anschließen an die Prüfbuchsen der Buchsenfelder des Prüfadapters.
Ausführungsform 18: Prüfsystem nach der vorhergehenden Ausführungsform, wobei das Messgerät ausgewählt ist aus der Gruppe bestehend aus: einem Multimeter, insbesondere einem Digitalmultimeter; einem Prüfgerät, welches der DIN EN IEC 61557-1 (VDE 0413-1): 2022-12 entspricht.
Ausführungsform 19: Verfahren zur Funktionsprüfung mindestens eines Ladekabels für Elektrofahrzeuge, wobei das Verfahren die Verwendung mindestens eines Prüfadapters nach einer der vorhergehenden, einen Prüfadapter betreffenden Ausführungsformen umfasst, wobei das Verfahren die folgenden Schritte umfasst:
   i. Anschließen mindestens eines ladestationsseitigen Steckers des Ladekabels an den ersten Steckeranschluss des Prüfadapters;
   ii. Anschließen mindestens eines fahrzeugseitigen Steckers des Ladekabels an den zweiten Steckeranschluss des Prüfadapters;
   iii. Verbinden mindestens zweier Prüfanschlüsse mindestens eines Messgerätes mit mindestens zwei Prüfbuchsen der Buchsenfelder; und
   iv. Erfassen mindestens eines elektrischen Parameters des Ladekabels mittels des Messgerätes.
Ausführungsform 20: Verfahren nach der vorhergehenden Ausführungsform, wobei der elektrische Parameter ausgewählt ist aus der Gruppe bestehend aus: einem Leitungswiderstand des Ladekabels; einem Isolationswiderstand des Ladekabels.
Ausführungsform 21: Verfahren nach einer der vorhergehenden, ein Verfahren betreffenden Ausführungsformen, wobei das Verfahren weiterhin eine Sichtprüfung des Ladekabels umfasst.
Ausführungsform 22: Verfahren nach einer der vorhergehenden, ein Verfahren betreffenden Ausführungsformen, wobei zum Erfassen des mindestens einen elektrischen Parameters ein Messgerät, ausgewählt aus der Gruppe bestehend aus einem Multimeter, insbesondere einem Digitalmultimeter und einem Prüfgerät gemäß der DIN EN IEC 61557-1 (VDE 0413-1): 2022-12, verwendet wird.
Ausführungsform 23: Verfahren nach einer der vorhergehenden, ein Verfahren betreffenden Ausführungsformen wobei das Verfahren eine Messung eines Innenwiderstandes des Prüfadapters umfasst, insbesondere vor Verfahrensschritt i..
Ausführungsform 24: Verfahren nach einer der vorhergehenden, ein Verfahren betreffenden Ausführungsformen, wobei zwischen Verfahrensschritt i. und Verfahrensschritt ii. eine Messung eines Widerstandswerts zwischen einem PE-Anschluss und einem Kodierungsanschluss des ladestationsseitigen Steckers durchgeführt wird.
Ausführungsform 25: Verfahren nach einer der vorhergehenden, ein Verfahren betreffenden Ausführungsformen, wobei in Verfahrensschritt iv. mindestens einer der folgenden elektrischen Parameter des Ladekabels erfasst wird, insbesondere alle der folgenden elektrischen Parameter in der angegebenen Reihenfolge:
   - ein Leitungswiderstand eines Schutzleiters PE;
   - ein Leitungswiderstand eines Neutralleiters N;
   - ein Leitungswiderstand eines Außenleiters L1;
   - ein Leitungswiderstand eines Außenleiters L2; und
   - ein Leitungswiderstand eines Außenleiters L3.
Ausführungsform 26: Verfahren nach einer der vorhergehenden, ein Verfahren betreffenden Ausführungsformen, wobei in Verfahrensschritt iv. mindestens einer der folgenden elektrischen Parameter des Ladekabels erfasst wird, insbesondere alle der folgenden elektrischen Parameter in der angegebenen Reihenfolge:
   - ein Isolationswiderstand zwischen Schutzleiter PE und Außenleiter L1;
   - ein Isolationswiderstand zwischen Schutzleiter PE und Außenleiter L2;
   - ein Isolationswiderstand zwischen Schutzleiter PE und Außenleiter L3;
   - ein Isolationswiderstand zwischen Schutzleiter PE und Neutalleiter N;
   - ein Isolationswiderstand zwischen Neutralleiter N und Außenleiter L1;
   - ein Isolationswiderstand zwischen Neutralleiter N und Außenleiter L2;
   - ein Isolationswiderstand zwischen Neutralleiter N und Außenleiter L3;
   - ein Isolationswiderstand zwischen Außenleiter L3 und Außenleiter L2;
   - ein Isolationswiderstand zwischen Außenleiter L3 und Außenleiter L1; und
   - ein Isolationswiderstand zwischen Außenleiter L1 und Außenleiter L2.
Ausführungsform 27: Verfahren nach einer der vorhergehenden, ein Verfahren betreffenden Ausführungsformen, wobei der Prüfadapter weiterhin ausgestaltet ist, um zusätzlich mindestens ein Notladekabel für Elektrofahrzeuge einer Funktionsprüfung zu unterziehen, wobei der Prüfadapter weiterhin aufweist:
   - mindestens einen mehrpoligen dritten Steckeranschluss, wobei der mehrpolige dritte Steckeranschluss als Schutzkontakt-Steckeranschluss ausgestaltet ist, insbesondere nach CEE 7/4; und
   - mindestens einen Anschluss zur Verbindung mit einer Kaltgerätekupplung; wobei das Verfahren weiterhin umfasst:
      v. Anschließen eines Schutzkontaktsteckers des Notladekabels an den dritten Steckeranschluss und des fahrzeugseitigen Steckers des Notladekabels an den zweiten Steckeranschluss des Prüfadapters;
      vi. Verbinden des Messgeräts mit dem Prüfadapter über den Anschluss zur Verbindung mit einer Kaltgerätekupplung mittels einer Kaltgeräteleitung; und
      vii. Durchführen der Funktionsprüfung des Notladekabels.
Ausführungsform 28: Verfahren nach der vorhergehenden Ausführungsform, wobei die Funktionsprüfung des Notladekabels das Erfassen mindestens eines elektrischen Parameters des Notladekabels mittels des Messgeräts umfasst, wobei mindestens einer der folgenden elektrischen Parameter erfasst wird, insbesondere alle der folgenden elektrischen Parameter in der angegebenen Reihenfolge:
   - ein Leitungswiderstand eines Schutzleiters PE;
   - ein Isolationswiderstand zwischen Schutzleiter und Außenleiter L/Neutralleiter N;
   - ein Schutzleiterstrom von Außenleiter L über Neutralleiter N;
   - ein Schutzleiterstrom von Neutralleiter N über Außenleiter L;
   - ein CP-Status eines Kodierungsanschlusses; und
   - eine Auslösezeit einer Fehlerstrom-Schutzeinrichtung (PRCD Auslösezeit).

### Kurze Beschreibung der Figuren

Weitere Einzelheiten und Merkmale ergeben sich aus der nachfolgenden Beschreibung von Ausführungsbeispielen, insbesondere in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigen:
- Figur 1A: ein Ausführungsbeispiel eines Prüfadapters zur Funktionsprüfung mindestens eines Ladekabels für Elektrofahrzeuge;
- Figuren 1B bis 1D: Schaltpläne des Prüfadapters nach Figur 1A;
- Figur 2: ein Flussdiagramm eines Ausführungsbeispiels eines Verfahrens zur Funktionsprüfung mindestens eines Ladekabels für Elektrofahrzeuge; und
- Figuren 3A bis 3C: verschiedene Konfigurationen des Prüfadapters während des Verfahrens zur Funktionsprüfung des Ladekabels für Elektrofahrzeuge.

### Beschreibung der Ausführungsbeispiele

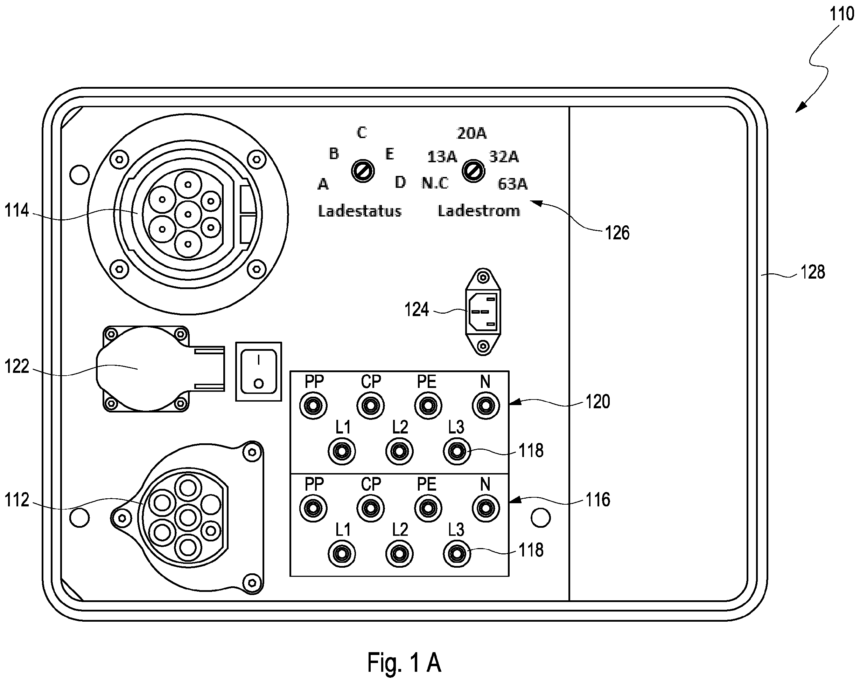

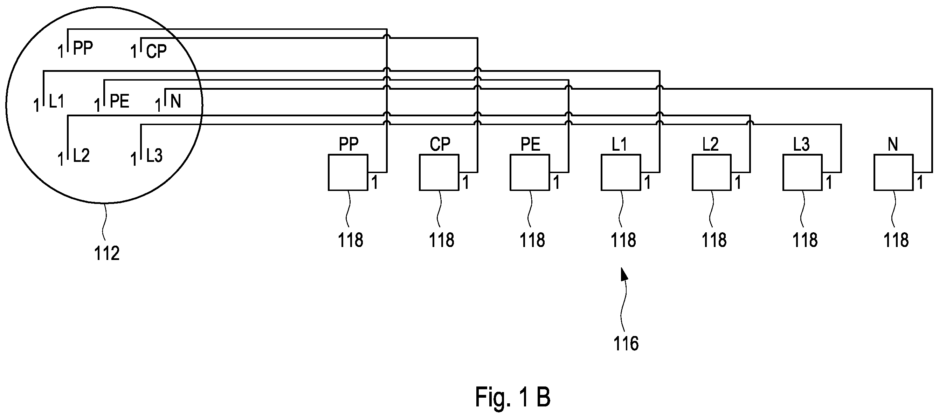

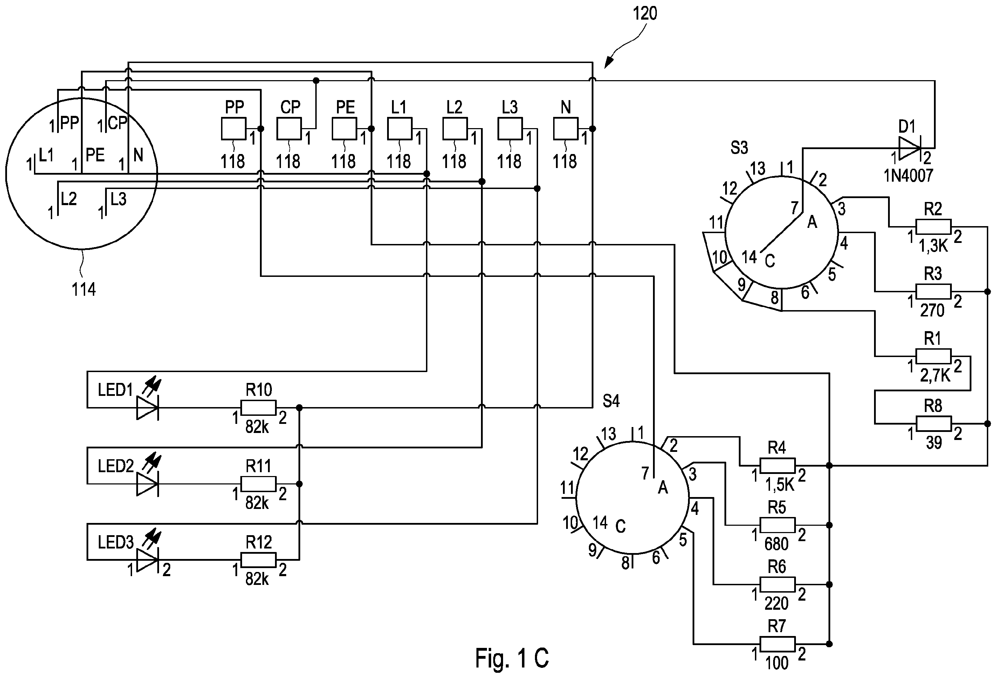

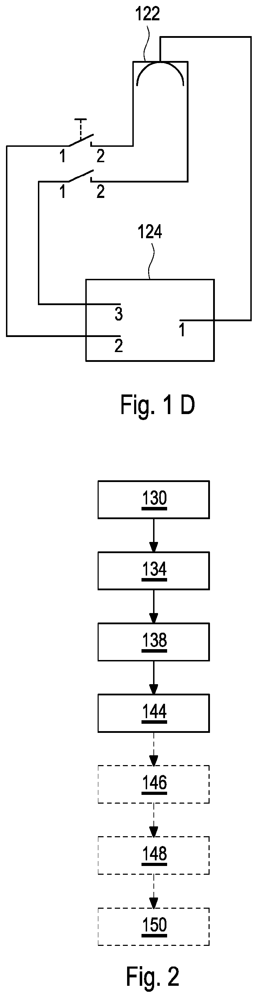

Figur 1A zeigt eine perspektivische Ansicht eines Ausführungsbeispiels eines Prüfadapters 110 zur Funktionsprüfung mindestens eines Ladekabels für Elektrofahrzeuge (nicht dargestellt in Figur 1). In diesem Beispiel ist der Prüfadapter 110 zur Funktionsprüfung eines Ladekabels vom Typ 2 des IEC 62196 Standards eingerichtet. In diesem Fall umfasst das Ladekabel sowohl einen ladestationsseitigen Stecker wie auch einen fahrzeugseitigen Stecker vom Typ 2 des IEC 62196 Standards. Das Ladekabel kann also ein Ladekabel Typ 2 auf Typ 2 umfassen. Grundsätzlich sind jedoch auch andere Ladekabeltypen denkbar, beispielsweise ein Ladekabel Typ 1 auf Typ 2, auch als "Mode-3-Kabel" bezeichnet.

Der Prüfadapter 110 umfasst mindestens einen mehrpoligen ersten Steckeranschluss 112 zum Anschließen mindestens eines ladestationsseitigen Steckers des Ladekabels und mindestens einen mehrpoligen zweiten Steckeranschluss 114 zum Anschließen mindestens eines fahrzeugseitigen Steckers des Ladekabels. Wie in diesem Ausführungsbeispiel in Figur 1 zu sehen ist, kann sowohl der erste Steckeranschluss 112 wie auch der zweite Steckeranschluss 114 den Anschluss eines Ladekabels vom Typ 2 des IEC 62196 Standards ermöglichen.

Der Prüfadapter 110 umfasst weiterhin mindestens ein erstes Buchsenfeld 116 mit mindestens zwei Prüfbuchsen 118, wobei die Prüfbuchsen 118 mit unterschiedlichen Anschlüssen des ersten Steckeranschlusses 112 elektrisch verbunden sind und bei an den ersten Steckeranschluss 112 angeschlossenem ladestationsseitigen Stecker des Ladekabels mit mindestens einem Prüfanschluss, insbesondere mindestens einer Messspitze, mindestens eines Messgerätes verbindbar sind.

Weiterhin umfasst der Prüfadapter 110 mindestens ein zweites Buchsenfeld 120 mit mindestens zwei Prüfbuchsen 118, wobei die Prüfbuchsen 118 mit unterschiedlichen Anschlüssen des zweiten Steckeranschlusses 114 elektrisch verbunden sind und bei an den zweiten Steckeranschluss 114 angeschlossenem fahrzeugseitigem Stecker des Ladekabels mit mindestens einem Prüfanschluss, insbesondere mindestens einer Messspitze, des Messgerätes verbindbar sind.

Die Steckeranschlüsse 112, 114 und die Prüfbuchsen 118 können derart ausgestaltet sein, dass jedem Anschluss in dem ladestationsseitigen Stecker des Ladekabels mindestens eine Prüfbuchse 118 des ersten Buchsenfeldes 116 elektrisch zugeordnet ist, und dass jedem Anschluss in dem fahrzeugseitigen Stecker des Ladekabels mindestens eine Prüfbuchse 118 des zweiten Buchsenfeldes 120 elektrisch zugeordnet ist. Die Verschaltung der Steckanschlüsse 112, 114 mit den Prüfbuchsen 118 des jeweiligen Buchsenfelds 116, 120 ist in den Figuren 1B und 1C dargestellt. So ist in Figur 1B der Schaltplan des ersten Steckeranschlusses 112 und des ersten Buchsenfeldes 116 mit den Prüfbuchsen 118 dargestellt. In Figur 1C ist der Schaltplan des zweiten Steckeranschlusses 114 und des zweiten Buchsenfeldes 120 mit den Prüfbuchsen 118 dargestellt. Wie in Figur 1B zu sehen ist, kann das erste Buchsenfeld 116 jeweils eine Prüfbuchse 118 aufweisen, die einem der folgenden Anschlüsse des ladestationsseitigen Steckers des Ladekabels zugeordnet ist: einem PE-Anschluss; einem N-Anschluss; einem L1-Anschluss; einem L2-Anschluss; einem L3-Anschluss. Wie in Figur 1C zu sehen ist, kann das zweite Buchsenfeld 120 ebenso jeweils eine Prüfbuchse 118 aufweisen, die einem der folgenden Anschlüsse des fahrzeugseitigen Steckers des Ladekabels zugeordnet ist: einem PE-Anschluss; einem N-Anschluss; einem L1-Anschluss; einem L2-Anschluss; einem L3-Anschluss.

In dem Ausführungsbeispiel der Figuren 1A bis 1D kann mindestens einer der Steckeranschlüsse 112, 114 zusätzlich mindestens einen Kodierungsanschluss zum Erfassen einer Kodierung eines maximalen Ladestroms des Ladekabels aufweisen. Dies ist in den Schaltplänen der Figuren 1B und 1C dargestellt. Zusätzlich kann das erste Buchsenfeld 116 mindestens eine Prüfbuchse 118 aufweisen, welche mit dem Kodierungsanschluss des ersten Steckeranschlusses 112 elektrisch verbunden ist. Zusätzlich kann das zweite Buchsenfeld 120 zusätzlich mindestens eine Prüfbuchse 118 aufweisen, welche mit dem Kodierungsanschluss des zweiten Steckeranschlusses 114 elektrisch verbunden ist.

Weiterhin kann, wie in den Figuren 1B und 1C zu sehen ist, mindestens einer der Steckeranschlüsse 112, 114 zusätzlich mindestens einen Ladekabel-Erkennungsanschluss zum Erfassen eines Anschlusses eines Ladekabels aufweisen. Zusätzlich kann das erste Buchsenfeld 116 mindestens eine Prüfbuchse 118 aufweisen, welche mit dem Ladekabel-Erkennungsanschluss des ersten Steckeranschlusses 112 elektrisch verbunden ist. Zusätzlich kann das zweite Buchsenfeld 120 zusätzlich mindestens eine Prüfbuchse 118 aufweisen, welche mit dem Ladekabel-Erkennungsanschluss des zweiten Steckeranschlusses 114 elektrisch verbunden ist.

Zur Funktionsprüfung des Ladekabels für Elektrofahrzeuge kann das Ladekabel mit dem ersten Steckeranschluss 112 und dem zweiten Steckeranschluss 114 des Prüfadapters 110 verbunden werden. Das erste Buchsenfeld 116 und das zweite Buchsenfeld 120 können eine Schnittstelle für das Messgerät zur Beprobung der an die Steckeranschlüsse 112, 114 angeschlossenen Leiter des Ladekabels bereitstellen.

Der Prüfadapter 110 kann weiterhin derart ausgestaltet sein, um zusätzlich mindestens ein Notladekabel für Elektrofahrzeuge einer Funktionsprüfung zu unterziehen. Der Prüfadapter 110 kann, wie in dem Ausführungsbeispiel der Figur 1A zu sehen ist, weiterhin mindestens einen mehrpoligen dritten Steckeranschluss 122 aufweisen, wobei der mehrpolige dritte Steckeranschluss 122 als Schutzkontakt-Steckeranschluss ausgestaltet ist, insbesondere nach CEE 7/4. Zur Funktionsprüfung des Notladekabels kann das Notladekabel mit dem dritten Steckeranschluss 122 sowie dem zweiten Steckeranschluss 114 verbunden werden.

Der Prüfadapter 110 kann weiterhin mindestens einen Anschluss zur Verbindung mit einer Kaltgerätekupplung 124 umfassen. Der Anschluss zur Verbindung mit der Kaltgerätekupplung 124 kann dazu eingerichtet sein, um den Prüfadapter 110 mit einer Prüfsteckdose des Mess- oder Prüfgerätes über eine Kaltgeräteleitung zu verbinden. Der Anschluss zur Verbindung mit der Kaltgerätekupplung 124 kann mit dem zweiten Steckeranschluss 114 und dem dritten Steckeranschluss 122 derart elektrisch verbunden sein, dass eine Spannungsversorgung für die Funktionsprüfung des Notladekabels über eine an den Anschluss zur Verbindung mit einer Kaltgerätekupplung 124 angeschlossene Kaltgeräteleitung erfolgen kann. Der Prüfadapter 110 kann weiterhin mindestens eine Schnittstelle 126 zur Einstellung eines Ladestatus und/oder eines Ladstroms für die Funktionsprüfung des Notladekabels umfassen. Die Verschaltung des dritten Steckeranschlusses 122 mit dem Anschluss zur Verbindung mit der Kaltgerätekupplung 124 ist in Figur 1D dargestellt.

Der Prüfadapter 110, wie er in Figur 1A zu sehen ist, kann insbesondere als tragbarer Prüfadapter ausgestaltet sein. Hierbei können der erste Steckeranschluss 112, der zweite Steckeranschluss 114, das erste Buchsenfeld 116 und das zweite Buchsenfeld 120 in einem gemeinsamen Gehäuse 128 angeordnet sein. Das Gehäuse 128 kann einen Koffer umfassen. Das Gehäuse 128 kann beispielsweise einen Hartschalenkoffer umfassen. Beispielsweise kann der Prüfadapter 110 ein Gewicht von ca. 3 kg, insbesondere mit den Maßen 41 cm x 32 cm x 17,5 cm, aufweisen.

Figur 2 zeigt ein Flussdiagramm eines Ausführungsbeispiels eines Verfahrens zur Funktionsprüfung mindestens eines Ladekabels für Elektrofahrzeuge. Das Verfahren umfasst die Verwendung mindestens eines erfindungsgemäßen Prüfadapters 110, beispielsweise gemäß der oben in den Figuren 1A bis 1D beschriebenen Ausführungsform und/oder gemäß einer der anderen, hierin beschriebenen Ausführungsformen.

Das Verfahren umfasst die nachfolgend beschriebenen Schritte. Die beschriebenen Schritte können insbesondere in der genannten Reihenfolge durchgeführt werden. Auch eine andere Reihenfolge ist jedoch grundsätzlich möglich. Weiterhin ist es möglich, dass zwei oder mehr der Verfahrensschritte zeitlich überlappend oder gleichzeitig durchgeführt werden. Weiterhin ist es möglich, dass einer oder mehrere der Verfahrensschritte einfach oder auch mehrfach wiederholt durchgeführt werden. Das Verfahren kann weitere Verfahrensschritte umfassen, welche nicht dargestellt sind.

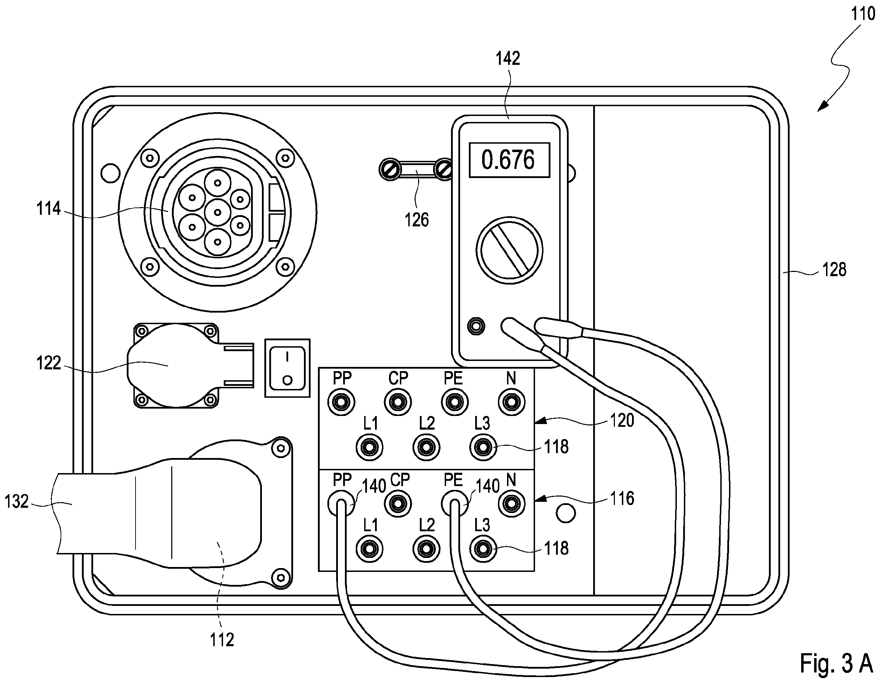

Die verschiedenen Schritte und die damit einhergehenden Konfigurationen des Prüfadapters 110 während des Verfahrens zur Funktionsprüfung des Ladekabels für Elektrofahrzeuge sind in den Figuren 3A bis 3C dargestellt. Daher wird im Folgenden das Verfahren in Figur 2 und die in den Figuren 3A bis 3C dargestellten Konfigurationen des Prüfadapters 110 gemeinsam beschrieben.

Das Verfahren umfasst die folgenden Schritte:
i. (gekennzeichnet durch Bezugszeichen 130) Anschließen mindestens eines ladestationsseitigen Steckers 132 des Ladekabels an den ersten Steckeranschluss 112 des Prüfadapters 110;
ii. (gekennzeichnet durch Bezugszeichen 134) Anschließen mindestens eines fahrzeugseitigen Steckers 136 des Ladekabels an den zweiten Steckeranschluss 114 des Prüfadapters 110;
iii. (gekennzeichnet durch Bezugszeichen 138) Verbinden mindestens zweier Prüfanschlüsse 140 mindestens eines Messgerätes 142 mit mindestens zwei Prüfbuchsen 118 der Buchsenfelder 116, 120; und
iv. (gekennzeichnet durch Bezugszeichen 144) Erfassen mindestens eines elektrischen Parameters des Ladekabels mittels des Messgerätes 142.

Zwischen Verfahrensschritt i. und Verfahrensschritt ii. kann weiterhin eine Messung eines Widerstandswerts zwischen einem PE-Anschluss und einem Kodierungsanschluss des ladestationsseitigen Steckers 132 durchgeführt werden. Diese Situation ist in Figur 3A dargestellt. Wie in Figur 3A zu sehen ist, kann die Messung des Widerstandwerts zwischen dem PE-Anschluss und dem Kodierungsanschluss des ladestationsseitigen Steckers 132 mit am ersten Steckeranschluss 112 angeschlossenem ladestationsseitigen Stecker 132 aber ohne am zweiten Steckeranschluss 114 angeschlossenen fahrzeugseitigen Stecker 136 erfolgen.

In Verfahrensschritt iv. kann mindestens einer der folgenden elektrischen Parameter des Ladekabels erfasst werden, insbesondere alle der folgenden elektrischen Parameter in der angegebenen Reihenfolge:
- ein Leitungswiderstand eines Schutzleiters PE;
- ein Leitungswiderstand eines Neutralleiters N;
- ein Leitungswiderstand eines Außenleiters L1;
- ein Leitungswiderstand eines Außenleiters L2; und
- ein Leitungswiderstand eines Außenleiters L3.

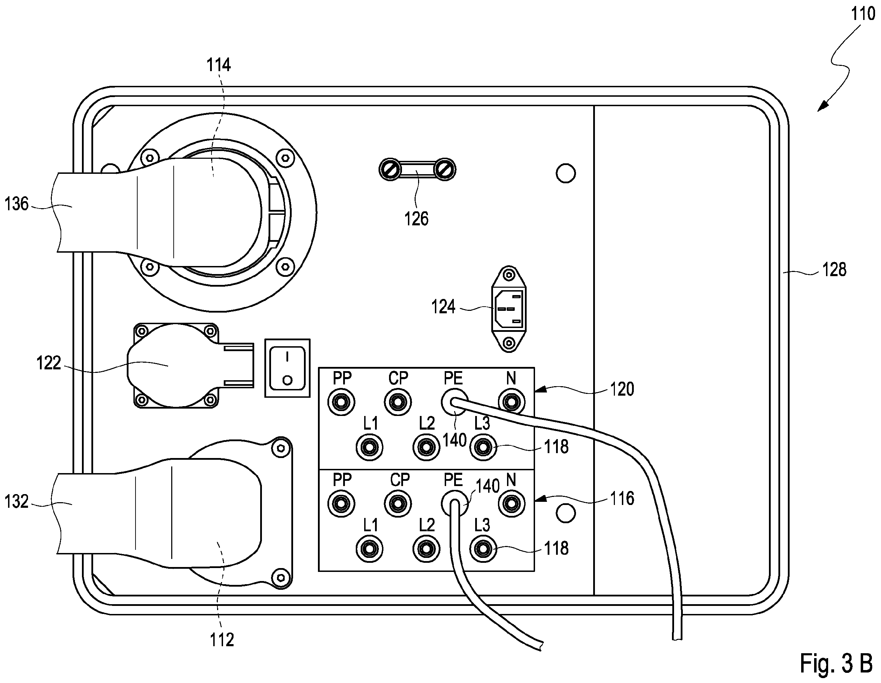

Für die Erfassung dieser elektrischen Parameter kann sowohl der ladestationsseitige Stecker 132 am ersten Steckeranschluss 112 wie auch der fahrzeugseitige Stecker 136 am zweiten Steckeranschluss 114 angeschlossen sein. Diese Situation ist in Figur 3B dargestellt.

Alternativ oder zusätzlich kann in Verfahrensschritt iv. mindestens einer der folgenden elektrischen Parameter des Ladekabels erfasst werden, insbesondere alle der folgenden elektrischen Parameter in der angegebenen Reihenfolge:
- ein Isolationswiderstand zwischen Schutzleiter PE und Außenleiter L1;
- ein Isolationswiderstand zwischen Schutzleiter PE und Außenleiter L2;
- ein Isolationswiderstand zwischen Schutzleiter PE und Außenleiter L3;
- ein Isolationswiderstand zwischen Schutzleiter PE und Neutalleiter N;
- ein Isolationswiderstand zwischen Neutralleiter N und Außenleiter L1;
- ein Isolationswiderstand zwischen Neutralleiter N und Außenleiter L2;
- ein Isolationswiderstand zwischen Neutralleiter N und Außenleiter L3;
- ein Isolationswiderstand zwischen Außenleiter L3 und Außenleiter L2;
- ein Isolationswiderstand zwischen Außenleiter L3 und Außenleiter L1; und
- ein Isolationswiderstand zwischen Außenleiter L1 und Außenleiter L2.

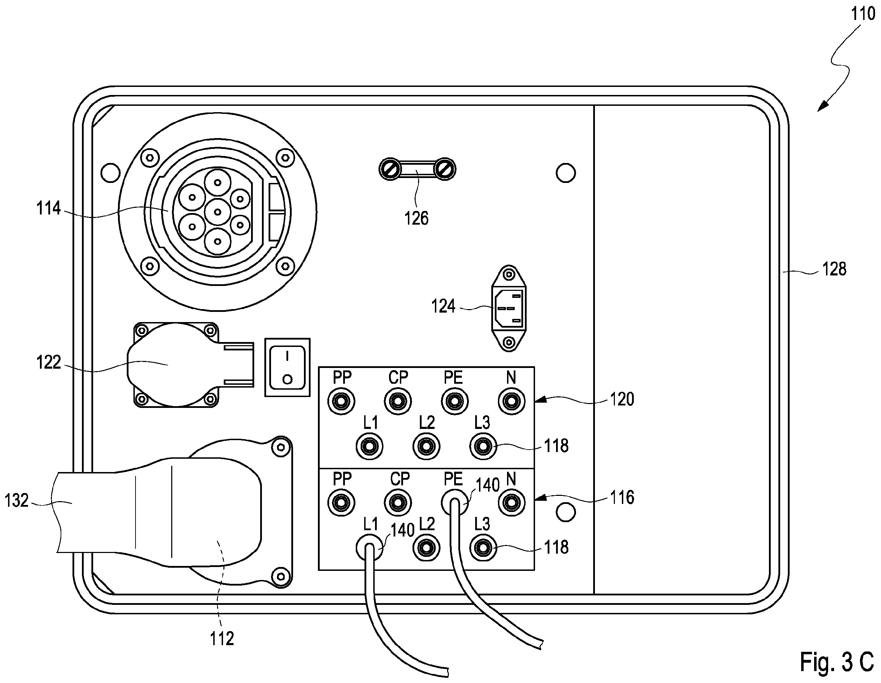

Für die Erfassung dieser elektrischen Parameter kann nur der ladestationsseitige Stecker 132 am ersten Steckeranschluss 112, nicht jedoch der fahrzeugseitige Stecker 136 am zweiten Steckeranschluss 114 angeschlossen sein. Diese Situation ist in Figur 3C dargestellt.

Der Prüfadapter 110 kann weiterhin, wie oben beschrieben, dazu ausgestaltet sein, um zusätzlich mindestens ein Notladekabel für Elektrofahrzeuge einer Funktionsprüfung zu unterziehen. Hierfür kann der Prüfadapter 110 den mindestens einen mehrpoligen dritten Steckeranschluss 122 aufweisen, wobei der mehrpolige dritte Steckeranschluss 122 als Schutzkontakt-Steckeranschluss ausgestaltet ist, insbesondere nach CEE 7/4, sowie den mindestens einen Anschluss zur Verbindung mit einer Kaltgerätekupplung 124.

Das Verfahren kann in diesem Fall weiterhin umfassen:
v. (gekennzeichnet durch Bezugszeichen 146) Anschließen eines Schutzkontaktsteckers des Notladekabels an den dritten Steckeranschluss 122 und des fahrzeugseitigen Steckers 136 des Notladekabels an den zweiten Steckeranschluss 114 des Prüfadapters 110;
vi. (gekennzeichnet durch Bezugszeichen 148) Verbinden des Messgeräts 142 mit dem Prüfadapter 110 über den Anschluss zur Verbindung mit einer Kaltgerätekupplung 124 mittels einer Kaltgeräteleitung; und
vii. (gekennzeichnet durch Bezugszeichen 150) Durchführen der Funktionsprüfung des Notladekabels.

Die Funktionsprüfung des Notladekabels kann über das Messgerät 142 laufen, sobald der Prüfkreis geschlossen ist, also insbesondere nach Schritt vi.. Ein Digitalmultimeter kann zum Messen des Widerstands (Ladestromkodierung) verwendet werden.

Die Funktionsprüfung des Notladekabels kann das Erfassen mindestens eines elektrischen Parameters des Notladekabels mittels des Messgeräts 142 umfassen, wobei mindestens einer der folgenden elektrischen Parameter erfasst wird, insbesondere alle der folgenden elektrischen Parameter in der angegebenen Reihenfolge:
- ein Leitungswiderstand eines Schutzleiters PE;
- ein Isolationswiderstand zwischen Schutzleiter und Außenleiter L/Neutralleiter N;
- ein Schutzleiterstrom von Außenleiter L über Neutralleiter N;
- ein Schutzleiterstrom von Neutralleiter N über Außenleiter L;
- ein CP-Status eines Kodierungsanschlusses; und
- eine Auslösezeit einer Fehlerstrom-Schutzeinrichtung (PRCD Auslösezeit).

Die Einhaltung der Reihenfolge der Erfassung der elektrischen Parameter kann insbesondere die vollständige Erfassung aller erforderlichen Parameter sicherstellen sowie die Dokumentation der Messergebnisse erleichtern.

### Bezugszeichenliste

- 110: Prüfadapter
- 112: erster Steckeranschluss
- 114: zweiter Steckeranschluss
- 116: erstes Buchsenfeld
- 118: Prüfbuchse
- 120: zweites Buchsenfeld
- 122: dritte Steckeranschluss
- 124: Anschluss zur Verbindung mit einer Kaltgerätekupplung
- 126: Schnittstelle
- 128: Gehäuse
- 130: Anschließen eines ladestationsseitigen Steckers an den ersten Steckeranschluss
- 132: ladestationsseitiger Stecker
- 134: Anschließen eines fahrzeugseitigen Steckers an den zweiten Steckeranschluss
- 136: fahrzeugseitiger Stecker
- 138: Verbinden zweier Prüfanschlüsse mit zwei Prüfbuchsen
- 140: Prüfanschluss
- 142: Messgerät
- 144: Erfassen eines elektrischen Parameters
- 146: Anschließen eines Schutzkontaktsteckers an den dritten Steckeranschluss und des fahrzeugseitigen Steckers an den zweiten Steckeranschluss
- 148: Verbinden des Messgeräts mit dem Prüfadapter
- 150: Durchführen der Funktionsprüfung des Notladekabels

## Patentansprüche

1. Prüfadapter (110) zur Funktionsprüfung mindestens eines Ladekabels für Elektrofahrzeuge, umfassend:
a. mindestens einen mehrpoligen ersten Steckeranschluss (112) zum Anschließen mindestens eines ladestationsseitigen Steckers (132) des Ladekabels;
b. mindestens einen mehrpoligen zweiten Steckeranschluss (114) zum Anschließen mindestens eines fahrzeugseitigen Steckers (136) des Ladekabels;
c. mindestens ein erstes Buchsenfeld (116) mit mindestens zwei Prüfbuchsen (118), wobei die Prüfbuchsen (118) mit unterschiedlichen Anschlüssen des ersten Steckeranschlusses (112) elektrisch verbunden sind und bei an den ersten Steckeranschluss (112) angeschlossenem ladestationsseitigen Stecker (132) des Ladekabels mit mindestens einem Prüfanschluss (140) mindestens eines Messgerätes (142) verbindbar sind; und
d. mindestens ein zweites Buchsenfeld (120) mit mindestens zwei Prüfbuchsen (118), wobei die Prüfbuchsen (118) mit unterschiedlichen Anschlüssen des zweiten Steckeranschlusses (114) elektrisch verbunden sind und bei an den zweiten Steckeranschluss (114) angeschlossenem fahrzeugseitigem Stecker (136) des Ladekabels mit mindestens einem Prüfanschluss (140) des Messgerätes (142) verbindbar sind.

2. Prüfadapter (110) nach dem vorhergehenden Anspruch, wobei der Prüfadapter (110) als tragbarer Prüfadapter ausgestaltet ist und wobei der erste Steckeranschluss (112), der zweite Steckeranschluss (114), das erste Buchsenfeld (116) und das zweite Buchsenfeld (120) in einem gemeinsamen Gehäuse (128) angeordnet sind.

3. Prüfadapter (110) nach einem der vorhergehenden Ansprüche, wobei die Steckeranschlüsse (112, 114) und die Prüfbuchsen (118) derart ausgestaltet sind, dass jedem Anschluss in dem ladestationsseitigen Stecker (132) des Ladekabels mindestens eine Prüfbuchse (118) des ersten Buchsenfeldes (116) elektrisch zugeordnet ist und dass jedem Anschluss in dem fahrzeugseitigen Stecker (136) des Ladekabels mindestens eine Prüfbuchse (118) des zweiten Buchsenfeldes (120) elektrisch zugeordnet ist.

4. Prüfadapter (110) nach einem der vorhergehenden Ansprüche, wobei das Ladekabel ausgewählt ist aus der Gruppe bestehend aus: einem Kabel für Drehstrom mit mindestens vier, insbesondere mindestens fünf Leitern; einem Kabel für Wechselstrom mit mindestens zwei, insbesondere mindestens drei Leitern.

5. Prüfadapter (110) nach einem der vorhergehenden Ansprüche, wobei das Ladekabel weiterhin mindestens eine Leitung aufweist, ausgewählt aus der Gruppe bestehend aus einer Kontrollleitung und einer Datenleitung.

6. Prüfadapter (110) nach einem der vorhergehenden Ansprüche, wobei mindestens einer der Steckeranschlüsse (112, 114) zusätzlich mindestens einen Kodierungsanschluss zum Erfassen einer Kodierung eines maximalen Ladestroms des Ladekabels aufweist, wobei das erste Buchsenfeld (116) zusätzlich mindestens eine Prüfbuchse (118) aufweist, welche mit dem Kodierungsanschluss des ersten Steckeranschlusses (112) elektrisch verbunden ist und/oder wobei das zweite Buchsenfeld (120) zusätzlich mindestens eine Prüfbuchse (118) aufweist, welche mit dem Kodierungsanschluss des zweiten Steckeranschlusses (114) elektrisch verbunden ist.

7. Prüfadapter (110) nach einem der vorhergehenden Ansprüche, wobei mindestens einer der Steckeranschlüsse (112, 114) zusätzlich mindestens einen Ladekabel-Erkennungsanschluss zum Erfassen eines Anschlusses eines Ladekabels aufweist, wobei das erste Buchsenfeld (116) zusätzlich mindestens eine Prüfbuchse (118) aufweist, welche mit dem Ladekabel-Erkennungsanschluss des ersten Steckeranschlusses (112) elektrisch verbunden ist und/oder wobei das zweite Buchsenfeld (120) zusätzlich mindestens eine Prüfbuchse (118) aufweist, welche mit dem Ladekabel-Erkennungsanschluss des zweiten Steckeranschlusses (114) elektrisch verbunden ist.

8. Prüfadapter (110) nach einem der vorhergehenden Ansprüche, wobei der Prüfadapter (110) weiterhin ausgestaltet ist, um zusätzlich mindestens ein Notladekabel für Elektrofahrzeuge einer Funktionsprüfung zu unterziehen und wobei der Prüfadapter (110) weiterhin aufweist:
e. mindestens einen mehrpoligen dritten Steckeranschluss (122), wobei der mehrpolige dritte Steckeranschluss (122) als Schutzkontakt-Steckeranschluss ausgestaltet ist.

9. Prüfadapter (110) nach dem vorhergehenden Anspruch, wobei der Prüfadapter (110) weiterhin mindestens einen Anschluss zur Verbindung mit einer Kaltgerätekupplung (124) umfasst.

10. Prüfsystem zur Funktionsprüfung mindestens eines Ladekabels für Elektrofahrzeuge, umfassend:
I. mindestens einen Prüfadapter (110) nach einem der vorhergehenden Ansprüche;
II. mindestens ein Messgerät (142) mit mindestens zwei Prüfanschlüssen (140) zum Anschließen an die Prüfbuchsen (118) der Buchsenfelder (116, 120) des Prüfadapters (110).

11. Verfahren zur Funktionsprüfung mindestens eines Ladekabels für Elektrofahrzeuge, wobei das Verfahren die Verwendung mindestens eines Prüfadapters (110) nach einem der vorhergehenden, einen Prüfadapter (110) betreffenden Ansprüche umfasst, wobei das Verfahren die folgenden Schritte umfasst:
i. Anschließen mindestens eines ladestationsseitigen Steckers (132) des Ladekabels an den ersten Steckeranschluss (112) des Prüfadapters (110);
ii. Anschließen mindestens eines fahrzeugseitigen Steckers (136) des Ladekabels an den zweiten Steckeranschluss (114) des Prüfadapters (110);
iii. Verbinden mindestens zweier Prüfanschlüsse (140) mindestens eines Messgerätes (142) mit mindestens zwei Prüfbuchsen (118) der Buchsenfelder (116, 120); und
iv. Erfassen mindestens eines elektrischen Parameters des Ladekabels mittels des Messgerätes (142).

12. Verfahren nach dem vorhergehenden Anspruch, wobei zwischen Verfahrensschritt i. und Verfahrensschritt ii. eine Messung eines Widerstandswerts zwischen einem PE-Anschluss und einem Kodierungsanschluss des ladestationsseitigen Steckers (132) durchgeführt wird.

13. Verfahren nach einem der vorhergehenden, ein Verfahren betreffenden Ansprüche, wobei in Verfahrensschritt iv. mindestens einer der folgenden elektrischen Parameter des Ladekabels erfasst wird, insbesondere in der angegebenen Reihenfolge:
- ein Leitungswiderstand eines Schutzleiters PE;
- ein Leitungswiderstand eines Neutralleiters N;
- ein Leitungswiderstand eines Außenleiters L1;
- ein Leitungswiderstand eines Außenleiters L2; und
- ein Leitungswiderstand eines Außenleiters L3.

14. Verfahren nach einem der vorhergehenden, ein Verfahren betreffenden Ansprüche, wobei in Verfahrensschritt iv. mindestens einer der folgenden elektrischen Parameter des Ladekabels erfasst wird, insbesondere in der angegebenen Reihenfolge:
- ein Isolationswiderstand zwischen Schutzleiter PE und Außenleiter L1;
- ein Isolationswiderstand zwischen Schutzleiter PE und Außenleiter L2;
- ein Isolationswiderstand zwischen Schutzleiter PE und Außenleiter L3;
- ein Isolationswiderstand zwischen Schutzleiter PE und Neutalleiter N;
- ein Isolationswiderstand zwischen Neutralleiter N und Außenleiter L1;
- ein Isolationswiderstand zwischen Neutralleiter N und Außenleiter L2;
- ein Isolationswiderstand zwischen Neutralleiter N und Außenleiter L3;
- ein Isolationswiderstand zwischen Außenleiter L3 und Außenleiter L2;
- ein Isolationswiderstand zwischen Außenleiter L3 und Außenleiter L1; und
- ein Isolationswiderstand zwischen Außenleiter L1 und Außenleiter L2.

15. Verfahren nach einem der vorhergehenden, ein Verfahren betreffenden Ansprüche, wobei der Prüfadapter (110) weiterhin ausgestaltet ist, um zusätzlich mindestens ein Notladekabel für Elektrofahrzeuge einer Funktionsprüfung zu unterziehen, wobei der Prüfadapter (110) weiterhin aufweist:
- mindestens einen mehrpoligen dritten Steckeranschluss (122), wobei der mehrpolige dritte Steckeranschluss (122) als Schutzkontakt-Steckeranschluss ausgestaltet ist; und
- mindestens einen Anschluss zur Verbindung mit einer Kaltgerätekupplung (124);
wobei das Verfahren weiterhin umfasst:
v. Anschließen eines Schutzkontaktsteckers des Notladekabels an den dritten Steckeranschluss (122) und des fahrzeugseitigen Steckers (136) des Notladekabels an den zweiten Steckeranschluss (114) des Prüfadapters (110);
vi. Verbinden des Messgeräts (142) mit dem Prüfadapter (110) über den Anschluss zur Verbindung mit einer Kaltgerätekupplung (124) mittels einer Kaltgeräteleitung; und
vii. Durchführen der Funktionsprüfung des Notladekabels, wobei die Funktionsprüfung des Notladekabels das Erfassen mindestens eines elektrischen Parameters des Notladekabels mittels des Messgeräts (142) umfasst, wobei mindestens einer der folgenden elektrischen Parameter erfasst wird, insbesondere in der angegebenen Reihenfolge:
- ein Leitungswiderstand eines Schutzleiters PE;
- ein Isolationswiderstand zwischen Schutzleiter und Außenleiter L/Neutralleiter N;
- ein Schutzleiterstrom von Außenleiter L über Neutralleiter N;
- ein Schutzleiterstrom von Neutralleiter N über Außenleiter L;
- ein CP-Status eines Kodierungsanschlusses; und
- eine Auslösezeit einer Fehlerstrom-Schutzeinrichtung (PRCD Auslösezeit).
